# EUROPEAN PATENT APPLICATION

(11) **EP 4 760 756 A1**
(43) Date of publication of application: **17.06.2026**
(21) Application number: 25222792.1
(22) Date of filing: 12.12.2025
(51) Int. Cl.: H01B 13/012

(54) **AN ANIMATION/GIF BASED METHOD FOR MANUFACTURING OF WIRING HARNESSES**

(30) Priority: 12.12.2024 IN 202421098343
(71) Applicant: Vertiv Corporation, Westerville, OH 43082 (US)
(72) Inventor: BHANGRE, Piyush Balkrishna, Westerville, 43082 (US); PANDITKAR, Rupesh, Westerville, 43082 (US); TAP, Prafull, Westerville, 43082 (US)
(74) Representative: Bryn-Jacobsen, Caelia

(57) **Abstract**

A method for manufacturing a wiring harness on the basis of into one or more GIF or animation-based engineering files **106** is disclosed. The 1:1 scale engineering drawing of a wiring harness is converted into one or more GIF or animation-based engineering files **106** through a format conversion module **104.** The GIF or animation-based engineering files **106** are distributed to a plurality of manufacturing units **119.** Thereafter, the one or more GIF or animation-based engineering files **106** are projected onto a reusable build board **112** by a projection setup module **110.** The various components of the wiring harness are secured on the reusable build board **112** through clamps. A quality check module **116** checks the accuracy of component placement with respect to the one or more GIF or animation-based engineering files **106.** Thereafter, an onboarding testing module **118** performs real-time validation of the assembled wiring harness on the reusable build board **112.**

## Description

### TECHNICAL FIELD

The present invention generally relates to the field of wiring harnesses and more particularly to a method for manufacturing wiring harnesses.

### BACKGROUND

Wiring harness manufacturing has historically relied on manual assembly techniques utilizing paper-based engineering drawings to guide the process. These conventional methods require significant operator skill to interpret technical specifications accurately, often resulting in variability in assembly quality and increased susceptibility to human error. The dependence on physical 1:1 scale drawings necessitates extensive manual handling, including the preparation, printing, and frequent updates of drawings, which inherently slows down production cycles and elevates operational costs. Design revisions further complicate the process, as they require reprinting and the physical replacement of drawings on the assembly boards, leading to inefficiencies in workflow and increased downtime. Additionally, the lack of real-time data synchronization and automated instructions in these traditional method hinders responsiveness to design changes and adaptation to varying production demands, thereby limiting overall manufacturing efficiency and scalability. These drawbacks underscore the technical challenges associated with existing wiring harness manufacturing methods and emphasize the need for improved solutions to enhance precision, reduce errors, and optimize production processes. There is, therefore felt a need for an animation/gif based method for manufacturing of wiring harnesses that alleviates the aforementioned drawbacks.

### SUMMARY OF THE INVENTION

This summary is provided to introduce aspects related to a method for manufacturing wiring harnesses. The disclosed method comprises of creating a 1:1 scale engineering drawing of a wiring harness and then converting it into a GIF or animation-based files for enhanced visual guidance. The converted GIF or animation-based files are stored and distributed to manufacturing units. The converted GIF or animation-based engineering drawing are displayed on to a reusable build board for guiding an assembly process. A component assembly module secures wiring harness components as guided by the converted GIF or animation-based engineering drawing. The placements of components is verified by a quality check module. An onboard testing module performs real-time validation of the assembled wiring harness on the build board. By providing drawing of a wiring harness in a GIF or animation-based files, the present invention provides precise visual guidance which reduces assembly errors and enhances workflow efficiency.

In an aspect, a method for manufacturing wiring harnesses is disclosed. The method comprises the steps of producing, by a drawing creation module, a 1:1 scale engineering drawing of a wiring harness, converting, by a format conversion module operatively linked to the drawing creation module, the engineering drawing into one or more GIF or animation-based engineering files for enhanced visual guidance, storing, managing, and distributing, by a file management module integrated with a product lifecycle management (PLM) or product data management (PDM), the converted GIF or animation-based files engineering files to a plurality of manufacturing units, displaying, by a projection setup module comprising a computer system and a projector, the converted GIF or animation-based files engineering files onto a reusable build board for guiding an assembly process, securing, by a component assembly module including the reusable build board equipped with a plurality of suction-based or magnetic clamps, wiring harness components as guided by the converted GIF or animation-based files engineering files, verifying, by a quality check module integrated with a plurality of sensors, the accuracy of component placement against the converted GIF or animation-based engineering files, and performing, by an onboard testing module, real-time validation of the assembled wiring harness on the reusable build board.

Other aspects and advantages of the invention will become apparent from the following description, taken in conjunction with the accompanying drawings, illustrating by way of example the principles of the invention.

### BRIEF DESCRIPTION OF THE DRAWINGS

The accompanying figures of the drawing, which are included to provide a further understanding of general aspects of the system/method, are incorporated in and constitute a part of this specification. These illustrative aspects of the system/method, and together with the detailed description, explain the principles of the system. No attempt is made to show structural details in more detail than is necessary for a fundamental understanding of the system and various ways in which it is practiced. The following figures of the drawing include:
**FIG. 1** illustrates a block diagram of module-based operation of method of manufacturing wiring harnesses.
**FIG. 2** illustrates a method flow associated with steps of manufacturing wiring harnesses.

In the appended figures, similar components and/or features may have the same numerical reference label. Further, various components of the same type may be distinguished by following the reference label with a letter. If only the first numerical reference label is used in the specification, the description is applicable to any one of the similar components and/or features having the same first numerical reference label irrespective of the suffix.

### LIST OF REFERENCE NUMERALS

100 - Method
**102** - Drawing Creation Module
**104** - Format Conversion Module
**106** - GIF or animation-based engineering files
**108** - File Management module
**110** - Projection Setup Module
**110a** - Computer system
**110b** - Projector
**112** - Reusable Build Board
**114** - Component Assembly Module
**116** - Quality Check Module
**118** - Onboard Testing Module
**120-** Manufacturing unit
**122-** Central Server
**124-** MES server
**126-** MES terminals

### DESCRIPTION OF THE INVENTION

Illustrative examples are described with reference to the accompanying drawings. Wherever convenient, the same reference numbers are used throughout the drawings to refer to the same or like parts. While examples and features of disclosed principles are described herein, modifications, adaptations, and other implementations are possible without departing from the scope of the disclosed examples. It is intended that the following detailed description be considered as exemplary only.

Wiring harness manufacturing has historically relied on manual assembly techniques utilizing paper-based engineering drawings to guide the process. These conventional methods require significant operator skill to interpret technical specifications accurately, often resulting in variability in assembly quality and increased susceptibility to human error. The dependence on physical 1:1 scale drawings necessitates extensive manual handling, including the preparation, printing, and frequent updates of drawings, which inherently slows down production cycles and elevates operational costs. Design revisions further complicate the process, as they require reprinting and the physical replacement of drawings on the assembly boards, leading to inefficiencies in workflow and increased downtime.

Additionally, the lack of real-time data synchronization and automated instructions in these traditional methods hinders responsiveness to design changes and adaptation to varying production demands, thereby limiting overall manufacturing efficiency and scalability. These drawbacks underscore the technical challenges associated with existing wiring harness manufacturing methods and emphasize the need for improved solutions to enhance precision, reduce errors, and optimize production processes.

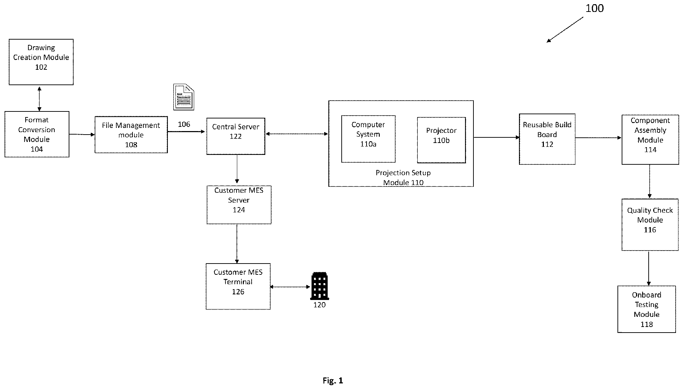

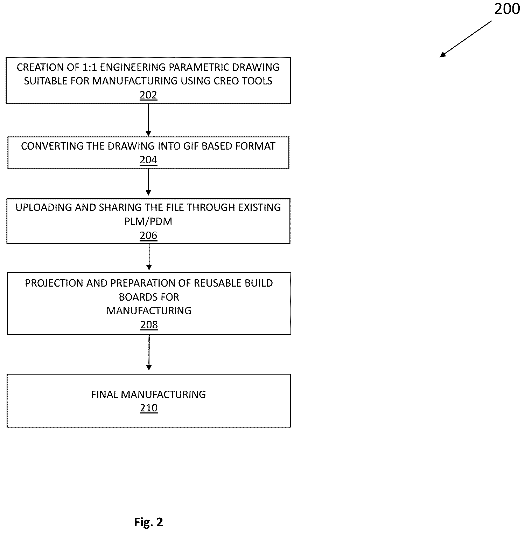

The disclosed method addresses this limitation by converting a 1:1 scale engineering drawing of a wiring harness and converting it into a GIF or animation-based engineering files. The GIF or animation-based engineering files provide visual guidance to an operator who is engaged in manufacturing of the wiring harness. The GIF or animation-based engineering files may be sent to different manufacturing units. The GIF or animation-based engineering files are projected to a reusable build board which is equipped with a plurality of suction-based or magnetic clamps. Once the assembly of the wiring harness is completed, its accuracy is verified by comparing the accuracy of component placement against the GIF or animation-based engineering files. Thereafter, real-time validation of the assembled wiring harness on the reusable build board is performed. The invention thus provides a method which provides precise visual guidance through GIF-based animations, reducing assembly errors. The faster conversion of engineering drawings into an animation-based format enhances workflow efficiency. The reduced manual intervention in the assembly process leads to consistent manufacturing output. The invention will now be described in detail with reference to **FIG. 1** and **FIG. 2****.** The examples do not limit the scope and ambit of the present disclosure.

**FIG. 1** illustrates a block diagram of module-based operation of method of manufacturing wiring harnesses. As shown in Fig. 1, a drawing creation module **102** creates a 1:1 scale engineering drawing of a wiring harness. Such a drawing may contain various components and measurements of the wiring harness.

The 1:1 scale engineering drawing is converted to into one or more GIF or animation-based engineering files **106** through a format conversion module **104**. The conversion module **104** is operatively linked to the drawing creation module **102**. The GIF or animation-based engineering files are a visual representation that uses sequential images or frames to convey step-by-step instructions in a dynamic and interactive manner. An operator will be able to understand the steps required in the manufacturing of the wiring harness by viewing the GIF or animation-based engineering files **106**.

The GIF or animation-based engineering files **106** can be stored, managed and distributed across a plurality of manufacturing units **119** through a file management module **108**. The manufacturing units **119** may be situated at different locations or within a same manufacturing facility. The file management module **108** is integrated with a product lifecycle management (PLM) or product data management (PDM) software/system. The PLM here refers to a strategic approach that manages a product's data, processes, and information throughout its entire lifecycle, from conception to disposal. The PDM here refers to a method for organizing, storing, and managing product-related data and design files 15 throughout the development and manufacturing process.

The converted GIF or animation-based files engineering files **106** are displayed on a reusable build board **112** through a projection setup module **110.** The projection setup module **110** comprises of a computer system **110a** and a projector **110b.** The computer system **110a** may be equipped with software designed to convert engineering drawings into animation-based formats and manage their visual display. The projector **110b** may be operatively connected to computer system **110a** and configured to project the converted drawings onto reusable build boards within the manufacturing environment. The reusable build board **112** guides an assembly process for manufacturing the wiring harness.

The reusable build board **112** is connected to a component assembly module **114** which is equipped with a plurality of suction-based or magnetic clamps. The plurality of suction-based or magnetic clamps are connected with various components of the wiring harness. The component assembly module **114** secures the wiring harness components according to the guidance provided by the converted GIF or animation-based files engineering files **106**.

Once the component assembly module **114** completes the assembly of the wiring harness, the accuracy of component placement with respect to the converted GIF or animation-based engineering files **106** is verified by a quality check module **116**.

After the verification, an onboard testing module **118** performs real-time validation of the assembled wiring harness on the reusable build board **112**.

In an example, projection instructions may be generated by the projection setup module **110**. The projection instructions are transmitted from a central server **122** to a customer MES ( Manufacturing Execution System) server **124**, and then to a plurality of MES terminals **124**, providing step-by-step visual aids that guide operators through the precise assembly of wiring harnesses. This allows operators to easily understand the steps of manufacturing wiring harnesses and monitor their manufacturing.

In an example, the central server **122** acts as the primary control unit that manages data flow between the file management module **108** and the projection setup module **110**. The central server **122** may be responsible for storing engineering drawings, converted projection files, and relevant manufacturing instructions. The central server **122** coordinates the seamless transfer of data to the customer MES server **124**, ensuring that all projection instructions are delivered promptly to maintain smooth operations across the manufacturing facility.

In an example, the customer MES server **124** functions as an intermediary data handler that receives projection instructions from the central server **122** and distributes them to the MES terminals **126** located throughout the manufacturing facility for wiring harnesses. The MES terminals **126** display these instructions in real time, providing operators with precise guidelines wiring harness assembly, which helps streamline the workflow and minimize the need for manual intervention during the assembly process.

In an example, a laser projector is integrated into the projector **110b** to deliver high-precision image projection and alignment capabilities. The projector **110b** significantly enhances the accuracy of projecting component placement guidelines onto the build boards, enabling more precise assembly.

In an example, the computer system **110a** may be operatively linked to both the central server **122** and the projection setup module **110.** The computer system **110a** may be equipped with software that can handle various file formats, such as .dwg, .dxf, and .drw, providing flexibility and compatibility in handling different types of manufacturing instructions.

In an example, the GIF or animation-based engineering files **106** may contain manufacturing animations and work instructions. Such manufacturing animations and work instructions may provide operators guidance on the steps involved in the manufacturing of the wiring harnesses.

In an example, the file management module **108** may use secure data transfer protocols to maintain integrity and confidentiality of the GIF or animation-based engineering file **106** during their transmissions to the projection setup module **110,** central server **122,** MES server **124** and MES terminals **126.**

In an example, the file management module **108** is configured to synchronize, in real-time, any modifications to the converted GIF or animation-based engineering files **106** to the plurality of manufacturing units 119.

In an example, a laser-guided alignment is integrated into the projection setup module **110** to align the projected image on the reusable build board **112** precisely.

In an example, an interface is provided that allows operators to interact with the animated projection. The operators may pause, rewind, or fast-forward the projection according to their assembly speed using the projection setup module **110.**

In an example, the reusable build board **112** is configured to be adjusted dynamically to accommodate various wiring harness designs through the component assembly module **114.**

In example, multiple operators can perform assembly tasks simultaneously.

In an example, the quality check module **116** is configured to provide real-time alerts and feedback to the operator.

In an example, the quality check module **116** is configured to capture and record the assembly process for subsequent analysis and quality check.

In example, the onboarding testing module **118** is configured to conduct a plurality of diagnostic tests.

In an example, the onboard testing module **118** is configured to initiate final assembly of the wiring harness upon successful validation of test results.

**FIG. 2** illustrates a method flow associated with steps of manufacturing wiring harnesses. As shown in Fig. 2, in step **202,** the a 1:1 scale engineering parametric drawing may be created using (computer-aided design) CAD tools like(CREO Parametric), tailored for precise manufacturing requirements. In the step **204,** the drawing created in the step 201 may be rapidly converted into a GIF or animation-based format, enhancing visual clarity and providing step-by-step assembly guidance. In step **206,** the converted file may be uploaded to a secure product lifecycle management (PLM) or product data management (PDM), enabling efficient and real-time distribution across different manufacturing facilities. In step **208,** using a high-precision projector, the GIF-based instructions are projected onto reusable build boards, facilitating quick setup and accurate component placement. In step **210,** in the final manufacturing phase, the wiring harness is assembled with improved precision and reduced manual intervention, ultimately enhancing production speed, accuracy, and consistency.

The methods, systems, devices, graphs, and/or tables discussed herein are examples. Various examples may omit, substitute, or add various procedures or components as appropriate. For instance, in alternative examples, the methods may be performed in an order different from that described, and/or various stages may be added, omitted, and/or combined. Also, features described with respect to certain examples may be combined in various other examples. Different aspects and elements of the examples may be combined in a similar manner. Also, technology evolves and, thus, many of the elements are examples and do not limit the scope of the disclosure or claims. Additionally, the techniques discussed herein may provide differing results with different types of context awareness classifiers.

Unless defined otherwise, all technical and scientific terms used herein have the same meaning as commonly or conventionally understood. As used herein, the articles "a" and "an" refer to one or to more than one (i.e., to at least one) of the grammatical object of the article. By way of example, "an element" means one element or more than one element. "About" and/or "approximately" as used herein when referring to a measurable value such as an amount, a temporal duration, and the like, encompasses variations of +20% or +10%, +5%, or +0.1% from the specified value, as such variations are appropriate to in the context of the systems, devices, circuits, methods, and other implementations described herein. "Substantially" as used herein when referring to a measurable value such as an amount, a temporal duration, a physical attribute (such as frequency), and the like, also encompasses variations of ±20% or ±10%, ±5%, or ±0.1% from the specified value, as such variations are appropriate to in the context of the systems, devices, circuits, methods, and other implementations described herein.

As used herein, including in the claims, "and" as used in a list of items prefaced by "at least one of" or "one or more of" indicates that any combination of the listed items may be used. For example, a list of "at least one of A, B, and C" includes any of the combinations A or B or C or AB or AC or BC and/or ABC (i.e., A and B and C). Furthermore, to the extent more than one occurrence or use of the items A, B, or C is possible, multiple uses of A, B, and/or C may form part of the contemplated combinations. For example, a list of "at least one of A, B, and C" may also include AA, AAB, AAA, BB, etc.
Further examples are set out in the clauses below:
1 A method for manufacturing wiring harnesses, the said method comprises the following steps:
   - producing, by a drawing creation module, a 1:1 scale engineering drawing of a wiring harness;
   - converting, by a format conversion module operatively linked to the drawing creation module, the engineering drawing into one or more GIF or animation-based engineering files for enhanced visual guidance;
   - storing, managing, and distributing, by a file management module integrated with a product lifecycle management (PLM) or product data management (PDM), the converted GIF or animation-based files engineering files to a plurality of manufacturing units;
   - displaying, by a projection setup module comprising a computer system and a projector, the converted GIF or animation-based files engineering files onto a reusable build board for guiding an assembly process;
   - securing, by a component assembly module including the reusable build board equipped with a plurality of suction-based or magnetic clamps, wiring harness components as guided by the converted GIF or animation-based files engineering files;
   - verifying, by a quality check module integrated with a plurality of sensors, the accuracy of component placement against the converted GIF or animation-based engineering files; and
   - performing, by an onboard testing module, real-time validation of the assembled wiring harness on the reusable build board.
2. The method as claimed in clause 1, wherein the said method further comprises embedding manufacturing animations and work instructions within converted GIF or animation-based engineering files.
3. The method as claimed in clause 1 or 2, wherein the said method further comprises employing secure data transfer protocols to maintain integrity and confidentiality of the converted GIF or animation-based engineering files during transmission using the file management module.
4. The method as claimed in any one of the preceding claims, wherein the said method further comprises synchronizing, in real-time, any modifications to the converted GIF or animation-based engineering files to the plurality of manufacturing units using the file management module.
5. The method as claimed in any one of the preceding claims, wherein the said method further comprises reading and displaying various file formats via the computer system operatively connected to a projector for projecting the converted GIF or animation-based engineering files onto a reusable build board using the projection setup module.
6. The method as claimed in any one of the preceding clauses, wherein the said method further comprises aligning the projected image precisely on the reusable build board using a laser-guided alignment integrated into the projection setup module.
7. The method as claimed in any one of the preceding clauses, wherein said method further comprises interacting with the animated projection via an interface that allows operators to pause, rewind, or fast-forward the projection according to their assembly speed using the projection setup module.
8. The method as claimed in any one of the preceding clauses, wherein the said method further comprises dynamically adjusting the reusable build board to accommodate various wiring harness designs via the component assembly module.
9. The method as claimed in any one of the preceding clauses, wherein said method further comprises allowing multiple operators to simultaneously perform assembly tasks.
10. The method as claimed in any one of the preceding clauses, wherein the said method further comprises providing real-time alerts and feedback to an operator via the quality control module.
11. The method as claimed in any one of the preceding clauses, wherein the said method further comprises capturing and recording the assembly process for subsequent analysis and quality check through the quality check module .
12. The method as claimed in any one of the preceding clauses, wherein the said method further comprises conducting a plurality of diagnostic tests via the onboard testing module.
13. The method as claimed in any one of the preceding clauses, wherein the said method further comprises initiating final assembly of the wiring harness upon successful validation of test results using the onboard testing module.
14. An apparatus to carry out the method as claimed in any one of the previous claims.

While illustrative and presently preferred examples of the disclosed systems, methods, and/or machine-readable media have been described in detail herein, it is to be understood that the inventive concepts may be otherwise variously embodied and employed, and that the appended claims are intended to be construed to include such variations, except as limited by the prior art. While the principles of the disclosure have been described above in connection with specific apparatuses and methods, it is to be clearly understood that this description is made only by way of example and not as limitation on the scope of the disclosure.

## Claims

1. A method for manufacturing wiring harnesses, the said method comprises the following steps:
• producing, by a drawing creation module **(102),** a 1:1 scale engineering drawing of a wiring harness;
• converting, by a format conversion module **(104)** operatively linked to the drawing creation module **(102),** the engineering drawing into one or more GIF or animation-based engineering files **(106)** for enhanced visual guidance;
• storing, managing, and distributing, by a file management module **(108)** integrated with a product lifecycle management (PLM) or product data management (PDM), the converted GIF or animation-based files engineering files **(106)** to a plurality of manufacturing units **(119);**
• displaying, by a projection setup module **(110)** comprising a computer system **(110a)** and a projector **(110b),** the converted GIF or animation-based files engineering files **(106)** onto a reusable build board **(112)** for guiding an assembly process;
• securing, by a component assembly module **(114)** including the reusable build board **(112)** equipped with a plurality of suction-based or magnetic clamps, wiring harness components as guided by the converted GIF or animation-based files engineering files **(106);**
• verifying, by a quality check module **(116)** integrated with a plurality of sensors, the accuracy of component placement against the converted GIF or animation-based engineering files **(106);** and
• performing, by an onboard testing module **(118),** real-time validation of the assembled wiring harness on the reusable build board **(112).**

2. . The method as claimed in claim 1, wherein the said method further comprises embedding manufacturing animations and work instructions within converted GIF or animation-based engineering files **(106).**

3. . The method as claimed in claim 1 or 2, wherein the said method further comprises employing secure data transfer protocols to maintain integrity and confidentiality of the converted GIF or animation-based engineering files **(106)** during transmission using the file management module **(108).**

4. . The method as claimed in any one of the previous claims, wherein the said method further comprises synchronizing, in real-time, any modifications to the converted GIF or animation-based engineering files **(106)** to the plurality of manufacturing units **(119)** using the file management module **(108).**

5. . The method as claimed in any one of the previous claims, wherein the said method further comprises reading and displaying various file formats via the computer system **(110a)** operatively connected to a projector **(110b)** for projecting the converted GIF or animation-based engineering files **(106)** onto a reusable build board **(112)** using the projection setup module **(110).**

6. . The method as claimed in any one of the previous claims, wherein the said method further comprises aligning the projected image precisely on the reusable build board **(112)** using a laser-guided alignment integrated into the projection setup module **(110).**

7. . The method as claimed in any one of the previous claims, wherein said method further comprises interacting with the animated projection via an interface that allows operators to pause, rewind, or fast-forward the projection according to their assembly speed using the projection setup module **(110).**

8. . The method as claimed in any one of the previous claims, wherein the said method further comprises dynamically adjusting the reusable build board **(112)** to accommodate various wiring harness designs via the component assembly module **(114).**

9. . The method as claimed in any one of the previous claims, wherein said method further comprises allowing multiple operators to simultaneously perform assembly tasks.

10. . The method as claimed in any one of the previous claims, wherein the said method further comprises providing real-time alerts and feedback to an operator via the quality control module.

11. . The method as claimed in any one of the previous claims, wherein the said method further comprises capturing and recording the assembly process for subsequent analysis and quality check through the quality check module **(116).**

12. . The method as claimed in any one of the previous claims, wherein the said method further comprises conducting a plurality of diagnostic tests via the onboard testing module **(118).**

13. . The method as claimed in any one of the previous claims, wherein the said method further comprises initiating final assembly of the wiring harness upon successful validation of test results using the onboard testing module **(118).**
